# EUROPEAN PATENT SPECIFICATION

(11) **EP 1 257 161 B1**
(45) Date of publication and mention of the grant of the patent: **26.07.2006**
(21) Application number: 01111624.1
(22) Date of filing: 12.05.2001
(51) Int. Cl.: H05K 9/00, H01R 13/646

(54) **An electric shielding arrangement with a generally concentric frame**
Elektrische Abschirmvorrichtung mit einer konzentrischen Struktur
Dispositif de blindage électrique à structure concentrique

(43) Date of publication of application: 13.11.2002
(73) Proprietor: SIEMENS AKTIENGESELLSCHAFT, 80333 München (DE)
(72) Inventor: Govin, Fabrice, 92400 Corbevoie (FR); Sage, Frederic, 78120 Ramboullet Cedex (FR)

(56) References cited:
- EP-A- 0 878 871
- FR-A- 2 704 361
- US-A- 6 042 421
- US-A- 6 120 306
- PATENT ABSTRACTS OF JAPAN vol. 013, no. 323 (E-791), 21 July 1989 (1989-07-21) -& JP 01 090595 A (MATSUSHITA ELECTRIC IND CO LTD), 7 April 1989 (1989-04-07)
- PATENT ABSTRACTS OF JAPAN vol. 1999, no. 14, 22 December 1999 (1999-12-22) -& JP 11 250954 A (ALPS ELECTRIC CO LTD), 17 September 1999 (1999-09-17)

## Description

The invention relates to an electric shielding arrangement comprising a main shielding enclosure structure and a generally concentric frame joined thereto that cooperatively form an electromagnetic radiation shield between an inside electric conductor and an outside space. High-frequency, low signal amplitude apparatuses have been using electric shielding arrangements to allow handling of electrical signals without electromagnetic interference from outside that could be fatal for correct measuring, amplifying, digitizing, and various other signal processing operations. The electric conductor will pass through the concentric frame and may outside fulfill various functions such as that of a high-frequency antenna. The transition from the well-shielded enclosure at the end of the concentric frame must be particularly well-designed, inasmuch as the latter will have to mate to the further shielding of the conductor that may be in the form of a pluggable cable.

The state of the art has manufactured the concentric frame as a mechanically separate item that is being soldered on the above main shielding. The present inventors have recognized such construction as a cause of extra costs as well as manufacturing faults. The manufacturing required the separate handling of two mechanical parts, the careful relative positioning thereof, and finally the applying of an interconnection such as by soldering. This represents an additional processing step imposing a fully different set of requirements from the mechanical forming of the two parts of the shield. The flow of solder and possibly associated soldering fluid, the application and removal of heat, and various other aspects of such soldering have been felt as causing inappropriate problems for producing a product that by itself is fully based on forming a rigid mechanical structure.

In consequence, amongst other things, it is an object of the present invention to obviate the need for such soldering whilst upholding the shielding quality and structural integrity of the shielding arrangement. Now therefore, according to one of its aspects the invention provides a main shielding enclosure structure and a concentric frame joined thereto that cooperatively form an electromagnetic radiation shield between an electric conductor located inside the shielding arrangement and the outside space, and the concentric frame is furthermore arranged for mating to an external coaxial conductor viz à viz said concentric frame, characterized in that said concentric frame is extrusion-formed from the main shielding enclosure structure and constitutes a single piece with said main shielding enclosure.

By itself, EP Published Patent Application 0 878 871 A1 corresponding to US Patent Application Serial No. 854 737 with a priority of May 12, 1997 discloses a female coax plug insulator that has a specific shape for controlling its electrical impedance and minimizing its Voltage Standing Wave Ratio. No details are being given regarding the manner of manufacturing the rigid metal parts thereof, other than by their mere dimensions, and in consequence, forming these by extrusion could have been an appropriate choice. However, the reference only relates to a substantially concentric arrangement, which does therefore not allow the shielding of a rather large electronic circuitry such as a printed circuit board like the present invention.

Likewise, US Patent 6,042,421 discloses a male coaxial connector that has both a rigid outer structure and flexible inside tongs for securing the position of its central connector pin. Like in the foregoing reference, no details were given on the manner of manufacturing the rigid metal parts thereof, other than their mere dimensions. Again as before, no combination with a main shielding enclosure for an electronic device as according to the present invention has been suggested in the reference.

Furthermore, US Patent 6,120, 306 discloses a cast coax header/socket connector system, cf. in particular, column 2, line 15 and column 3, line 47. The construction disclosed has been optimized for minimum crosstalk amongst a plurality of parallel lines arranged in said connector. Moreover, the art of designing multiwire connectors is approaching its goals from a side that is completely different from the present invention.

The present invention is indeed aiming to structurally join in a single piece of work a main, relatively thin, electric shielding structure that has a substantial area for shielding an electronic device, with a generally concentric frame for therein allowing to locate an electrical conductor. Generally, the dimensioning of a multi-wire connector, and such an electric shielding structure according to the present invention are far apart.

The invention also relates to a shielding enclosure comprising an electric shielding arrangement as claimed in Claim 1, and forming a first single-sided cover that is to be mated with a second single-sided cover and to an electronic apparatus arranged in a double-sided cover so constituted. Further advantageous aspects of the invention are recited in dependent Claims.

These and further aspects and advantages of the invention will be discussed more in detail hereinafter with reference to the disclosure of preferred embodiments, and in particular with reference to the appended Figures that show:
Figure 1, a soldered version of the shielding arrangement according to prior art;
Figure 2, an extruded version of the shielding arrangement of the present invention;
Figure 3, an "outside" view of the shielding enclosure of the present invention;
Figure 4, an "inside" view of the shielding enclosure of the present invention.

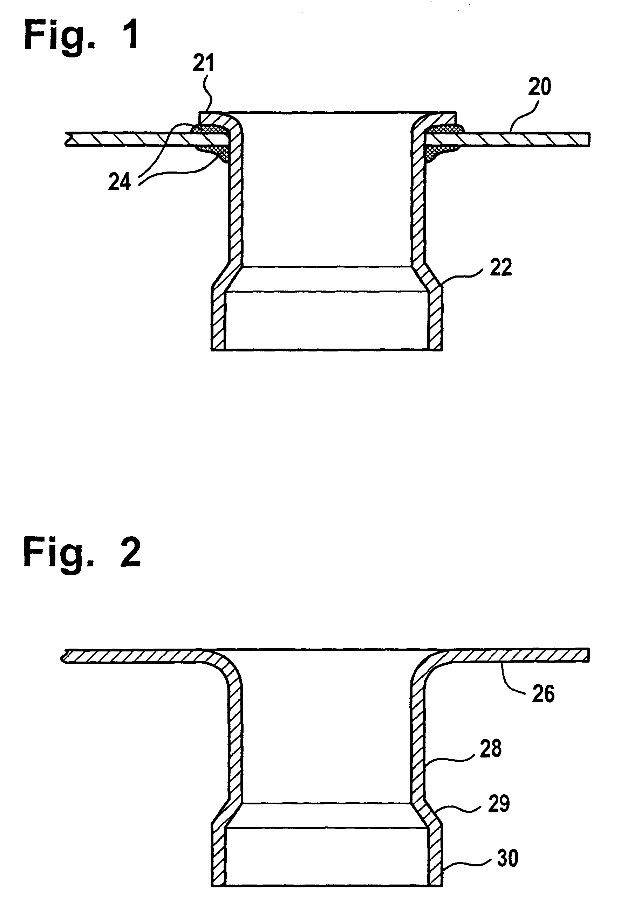

Figure 1 illustrates a soldered version of the shielding arrangement according to prior art. The arrangement comprises a main shielding enclosure structure 20 that may be 0.5 mm thick, and that is soldered by ring-soldering (24) to a substantially concentric frame 22, and which may have been standardized according to an ISO standard. As shown, before soldering, the edge 21 of the frame 22 may have been widened by a well known manufacturing step that will cause a certain plastic deforming of the concentric structure. The soldering, although fully feasible in principle, has proved to be a complicating and expensive factor to the manufacture. Next to the typical problems of handling articles at raised temperature, the soldering process itself represents a new process in the workroom of organizations that up to now have been expert mainly in mechanical forming and shaping. Moreover, the maintaining of quality standards is proving to be difficult for the prior art process.

Figure 2 illustrates an extruded version of the shielding arrangement according to the present invention. Generally, the main shielding enclosure structure 26 has the same thickness of 0,5 mm as before. However, now the concentric frame 28, 29, 30 has been extruded from the same material as the main shielding enclosure structure 26. In one realization, the extrusion did require eight successive steps, which allowed to maintain the strictest requirements for size, positioning, wall uniformity, concentric quality, and smoothness of the transition between the substantially flat shielding 26 and the extruded concentric frame 28, 29, 30. This concentric frame has a wall thickness of a value similar to the thickness of the main shielding enclosure structure 26. This means that its shape that is more or less a cylinder, is structurally sufficiently rigid for handling, as well as for connecting an external cable or wire. The conical shape of the transition 29 and the tubular sections 28 and 30 allow strictly tolerance-subjected dimensions, wherein the virtual apex of the cone was upward in the Figure as being directed towards the main shielding plate 26. Further processing steps for the manufacture were bending, cutting, punching of the box, connector board-to-board inserting, and finally the insertion from outside of an antenna pin with its plastic holder. The positioning of the antenna pin is done by the extrusion frame and two supporting bumps. The location of the board-to-board connector is also effected by one bending operation.

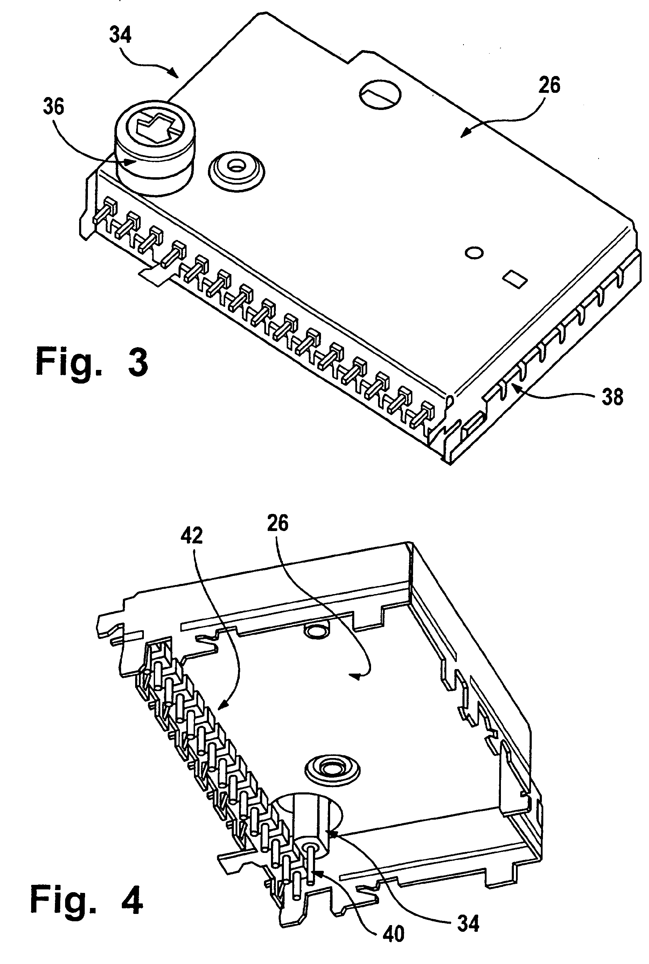

Figure 3 illustrates an "outside" view of a shielding enclosure according to the present invention. The electric shielding arrangement effectively constitutes a front cover of a shielding enclosure is to be combined with a rear cover 38. Their mutual fastening is effected through various tooth-like structures shown more in particular in Figure 4. Furthermore, item 36 is an ISO-standardized extruded frame, that inside has a plastic contact holder 34 surrounding the antenna pin (40) centrally disposed therein. Various further details visible on the surface of the electric shielding arrangement are inconsequential for the present invention. This shielding enclosure may be used as a housing for an electronic device or circuit, and in particular for a tuner apparatus. In almost all cases, such an electronic circuit will have a shielded signal input as shown in Figures 3, 4, and furthermore an output for outputting a user signal such as audio or data.

Figure 4 illustrates the "inside" view of the shielding arrangement of the present invention, wherein the rear cover 38 of Figure 3 has been removed for better inspection. Again, assembly 26 fills most of the area, that furthermore carries the antenna pin 40 with the plastic contact holder 34, and board-to-board connector 42, of which the counterpart is also visible at the lower edge in Figure 3. Such board-to-board connectors have been the target of extensive standardization operations.

The plastic contact holder 34 locates the antenna pin 40 in a shielding by way of the extruded frame in the front cover. The holder 34 is advantageously constructed from ULTRAMID B3 W6G with 30% of glass fiber added. The extruded part 36 comes from pre-tinned band raw material such as DCO4 LC with a thickness of 0.5 millimeter. The eight-step extrusion sequence allowed to reach a height of 14 millimeters with an inside diameter of 9 millimeters. It has been experienced that organizations operational in the stamping business have far more knowledge about steel buckling and similar arts than about soldering processes. A final advantage of the invention is that it allows to only maintain an inventory of a single intermediate product, instead of two.

## Claims

1. An electric shielding arrangement comprising a main shielding enclosure structure (26) and a concentric frame (28, 29, 30) joined thereto that cooperatively form an electromagnetic radiation shield between an electric conductor (40) located inside said electric shielding arrangement and the outside space, and said concentric frame (28,29,30) is furthermore arranged for mating to an external coaxial conductor viz à viz said concentric frame (28,29,30), **characterized in that** said concentric frame (28, 29, 30) is extrusion-formed from said main shielding enclosure structure (26) and constitutes a single piece with said main shielding enclosure structure (26).

2. An electric shielding arrangement as claimed in Claim 1,
**characterized in that** said concentric frame comprises a conical shaped transition (29) that has a virtual apex directed towards said main shielding enclosure structure (26).

3. An electric shielding arrangement as claimed in Claim 1,
**characterized in that** said concentric frame (28, 29, 30) has a wall thickness of a value similar to the wall thickness of said shielding enclosure structure (26).

4. An electric shielding arrangement as claimed in Claim 1,
**characterized in that** said shielding enclosure structure (26) forms a substantially flat base for said concentric frame (28, 29, 30).

5. An electric shielding arrangement as claimed in Claim 1,
**characterized in that** said concentric frame (28, 29, 30) houses a plastic contact holder (34) that is surrounding the electrical conductor (40) centrally disposed therein.

6. An electric shielding arrangement as claimed in Claim 5,
**characterized in that** said centrally disposed electrical conductor (40) is an antenna pin.

7. An electric shielding arrangement as claimed in Claim 1,
**characterized in that** said electric shielding arrangement forms a front cover that is arranged for mating with a rear cover (38) in order that they constitute together a shielding enclosure.

8. A shielding enclosure comprising an electric shielding arrangement as claimed in Claim 1, **characterized in that** said shielding arrangement forms a front cover that is mated with a rear cover (38) in order that they constitute together a shielding enclosure.

9. An electronic apparatus contained in a shielding enclosure as claimed in Claim 8.

10. An electronic apparatus as claimed in Claim 9, said electronic apparatus being a tuner.

## Patentansprüche

1. Elektrische Abschirmanordnung, die folgendes umfaßt:
eine Abschirmkapselungshauptstruktur (26) und einen damit verbundenen konzentrischen Rahmen (28, 29, 30), die zusammen einen elektromagnetischen Strahlungsschirm zwischen einem elektrischen Leiter (40), der in der elektrischen Abschirmanordnung liegt, und dem Außenraum bilden, und der konzentrische Rahmen (28, 29, 30) ist zudem zum Koppeln an einen externen Koaxialleiter gegenüber dem konzentrischen Rahmen (28, 29, 30) ausgelegt, **dadurch gekennzeichnet, daß** der konzentrische Rahmen (28, 29, 30) über Extrudierung aus der Abschirmkapselungshauptstruktur (26) ausgebildet ist und ein einzelnes Stück mit der Abschirmkapselungshauptstruktur (26) bildet.

2. Elektrische Abschirmanordnung nach Anspruch 1, **dadurch gekennzeichnet, daß** der konzentrische Rahmen einen konisch gestalteten Übergang (29) aufweist, der eine virtuelle Spitze besitzt, die auf die Abschirmkapselungshauptstruktur (26) gerichtet ist.

3. Elektrische Abschirmanordnung nach Anspruch 1, **dadurch gekennzeichnet, daß** der konzentrische Rahmen (28, 29, 30) eine Wanddicke mit einem Wert aufweist, der der Wanddicke der Abschirmkapselungsstruktur (26) ähnlich ist.

4. Elektrische Abschirmanordnung nach Anspruch 1, **dadurch gekennzeichnet, daß** die Abschirmkapselungsstruktur (26) eine im wesentlichen flache Basis für den konzentrischen Rahmen (28, 29, 30) bildet.

5. Elektrische Abschirmanordnung nach Anspruch 1, **dadurch gekennzeichnet, daß** der konzentrische Rahmen (28, 29, 30) eine Kunststoffkontakthalterung (34) beherbergt, die den zentral darin angeordneten elektrischen Leiter (40) umgibt.

6. Elektrische Abschirmanordnung nach Anspruch 5, **dadurch gekennzeichnet, daß** der zentral angeordnete elektrische Leiter (40) ein Antennenstift ist.

7. Elektrische Abschirmanordnung nach Anspruch 1, **dadurch gekennzeichnet, daß** die elektrische Abschirmanordnung eine vordere Hülle bildet, die zum Koppeln mit einer hinteren Hülle (38) ausgelegt ist, damit sie zusammen eine Abschirmkapselung bilden.

8. Abschirmkapselung, die eine elektrische Abschirmanordnung wie in Anspruch 1 beansprucht umfaßt, **dadurch gekennzeichnet, daß** die Abschirmanordnung eine vordere Hülle bildet, die mit einer hinteren Hülle (38) gekoppelt wird, damit sie zusammen eine Abschirmkapselung bilden.

9. Elektronische Vorrichtung, die in einer Abschirmkapselung wie in Anspruch 8 beansprucht enthalten ist.

10. Elektronische Vorrichtung nach Anspruch 9, wobei die elektronische Vorrichtung ein Tuner ist.

## Revendications

1. Dispositif de blindage électrique comprenant une structure d'enveloppe de blindage principale (26) et un châssis concentrique (28, 29, 30) assemblé à celle-ci, qui forment en coopération un blindage contre le rayonnement électromagnétique entre un conducteur électrique (40) situé à l'intérieur dudit dispositif de blindage électrique et l'espace extérieur, et ledit châssis concentrique (28, 29, 30) est configuré en outre pour être connecté à un conducteur coaxial externe vis-à-vis dudit châssis concentrique (28, 29, 30), **caractérisé en ce que** ledit châssis concentrique (28, 29, 30) est formé par extrusion à partir de ladite structure d'enveloppe de blindage principale (26) et constitue une seule pièce avec ladite structure d'enveloppe de blindage principale (26).

2. Dispositif de blindage électrique selon la revendication 1,
**caractérisé en ce que** ledit châssis concentrique comprend une transition de forme conique (29) qui a un sommet virtuel dirigé vers ladite structure d'enveloppe de blindage principale (26).

3. Dispositif de blindage électrique selon la revendication 1,
**caractérisé en ce que** ledit châssis concentrique (28, 29, 30) a une épaisseur de paroi d'une valeur similaire à l'épaisseur de paroi de ladite structure d'enveloppe de blindage (26).

4. Dispositif de blindage électrique selon la revendication 1,
**caractérisé en ce que** ladite structure d'enveloppe de blindage (26) forme une base substantiellement plane pour ledit châssis concentrique (28, 29, 30).

5. Dispositif de blindage électrique selon la revendication 1,
**caractérisé en ce que** ledit châssis concentrique (28, 29, 30) loge un porte-contact en matière plastique (34) qui entoure le conducteur électrique (40) disposé à l'intérieur de celui-ci en son centre.

6. Dispositif de blindage électrique selon la revendication 5,
**caractérisé en ce que** ledit conducteur électrique disposé au centre (40) est une broche d'antenne.

7. Dispositif de blindage électrique selon la revendication 1,
**caractérisé en ce que** ledit dispositif de blindage électrique forme un couvercle avant qui est configuré pour être connecté avec un couvercle arrière (38) pour qu'ils constituent ensemble une enveloppe de blindage.

8. Enveloppe de blindage comprenant un dispositif de blindage électrique selon la revendication 1, **caractérisée en ce que** ledit dispositif de blindage forme un couvercle avant qui est connecté avec un couvercle arrière (38) pour qu'ils constituent ensemble une enveloppe de blindage.

9. Dispositif électronique contenu dans une enveloppe de blindage selon la revendication 8.

10. Dispositif électronique selon la revendication 9, ledit dispositif électronique étant un bloc d'accord.
